# EUROPEAN PATENT APPLICATION

(11) **EP 3 933 907 A1**
(43) Date of publication of application: **05.01.2022**
(21) Application number: 20183145.0
(22) Date of filing: 30.06.2020
(51) Int. Cl.: H01L 23/051, H01L 23/20, H01L 23/22, H01L 23/16, H01L 23/31

(54) **POWER SEMICONDUCTOR DEVICE**

(71) Applicant: ABB Schweiz AG, 5400 Baden (CH)
(72) Inventor: DOBRZYNSKA, Jagoda, 5600 Lenzburg (CH); VOBECKY, Jan, 5600 Lenzburg (CH); STIASNY, Thomas, 8820 Wädenswil (CH); GUILLON, David, 8857 Vorderthal (CH); WIKSTROEM, Tobias Mats Olof, 5704 Egliswil (CH)
(74) Representative: Qip Patentanwälte Dr. Kuehn & Partner mbB

(57) **Abstract**

The invention relates to a power semiconductor device, comprising a semiconductor wafer (1) having at least contact element (2) and a passivated junction termination (3) laterally surrounding the at least one contact element (2), and an insulating medium (4) selected from the group consisting of a dielectric liquid, a pressurized dielectric gas and a vacuum, wherein the semiconductor wafer (1) is surrounded by the insulating medium (4).

## Description

### Technical Field

The invention relates to power semiconductor device, comprising a semiconductor wafer having at least one contact element and a passivated junction termination laterally surrounding the at least one contact element. The present invention also relates to a use of the power semiconductor device.

### Background Art

Bipolar diode and thyristor power semiconductor devices are considered attractive as potential power semiconductors devices for subsea converters, transformer tap-changers and other oil immersed electronics systems, or next generation high-voltage, direct current, HVDC, compact converters, or high vacuum power generation space applications.

Discrete bipolar power semiconductor devices are typically packaged in a rubber protection around its junction termination and passivation and, when hermetically packed, then in atmospheric pressure. In application, the semiconductor wafer itself is mounted into a copper-ceramic housing between two molybdenum disks. Said housing-mounted semiconductor elements are inserted between coolers to form stacks, or are already clamped within a module, which are then used as parts of said converters and tap changers.

When an electric field at a p-n junction in an active region of the power semiconductor device reaches a critical value of the electric field for silicon E_{crit}≈200 kV/cm, an excessive impact ionization causes an electrical breakdown. When the p-n junction reaches a surface of the power semiconductor device and the electric field exceeds a dielectric strength Eₘₐₓ of an ambient dielectric, such as air, nitrogen, vacuum, oil etc., the dielectric breakdown occurs. The high electric field ionizes molecules and changes them from an insulator to a conductor. Because of the recombination of electrons and ions, sparks occur and the required blocking capability is lost. As the dry air or nitrogen shows only Eₘₐₓ ≤30 kV/cm, the edge of the semiconductor wafer or chip must be specially treated against the dielectric breakdown. Said part of the semiconductor wafer is called junction termination and represents the most sensitive region regarding t blocking capability and its long-term stability.

Today's power semiconductor devices configuration, however, are not tolerant against high hydrostatic external pressure i.e. higher than atmospheric pressure, or high vacuum, because typically thin housing flanges extending from pole pieces are lacking mechanical stability if the stack was to be immersed deep under water or in outer space with high vacuum.

### Summary of invention

It is therefore an object of the invention to provide a power semiconductor device that is tolerant against high hydrostatic external pressure and/or high vacuum.

The object of the invention is solved by the features of the independent claims. Modified implementations are detailed in the dependent claims.

Thus, the object is solved by a power semiconductor device, comprising
a semiconductor wafer having at least one contact element and a passivated junction termination laterally surrounding the at least one contact element, and
an isolating medium selected from the group consisting of a dielectric liquid, a pressurized dielectric gas and a vacuum, wherein
the semiconductor wafer is immersed and/or surrounded by the insulating medium.

It is therefore a key point that the semiconductor wafer is surrounded by the dielectric liquid, the pressurized dielectric gas or the vacuum. Such way the power semiconductor device is tolerant against high hydrostatic external pressure, in particular higher than atmospheric pressure or high vacuum. Thereby the power semiconductor device may only use materials compatible with the dielectric liquid, such as for example organic or synthetic oil, pressurized gas or high vacuum. Such ways the proposed power semiconductor device can advantageously be used in oil-containing applications, in pressurized gas-containing applications and in high vacuum-environment applications by immersion of the semiconductor wafer in the above specified insulating medium.

The semiconductor wafer can be provided 'housing-less' i.e. does not require any housing in particular directly enclosing the semiconductor wafer such that manufacturing becomes easier. The dielectric liquid, pressurized gas or vacuum assures that creepage and strike distance requirements are met. HTRB, high temperature reverse bias, tests have readily shown that semiconductor wafers such as for example diodes are functional if the insulating medium covers the contact element and passivated junction termination. The semiconductor device may be installed in a subsea converter, a transformer tap changer or a high voltage direct current converter, or in any other appliance. Said converter of appliance may comprise a housing, which 'houses' the dielectric liquid.

The semiconductor wafer may comprise a disc like shape with longitudinal surfaces. Opposite longitudinal surfaces of the semiconductor wafer may form opposite contact elements i.e. electrical contacts, whereas the junction termination is arranged at the lateral side between the opposite contact elements. The contact elements, for example anode, cathode and gate regions of the power semiconductor device, can be provided with a copper metallization, aluminum metallization or other high conductive metals as electrical contacts and/or electrodes. Passivated means that the surface of the semiconductor wafer is rendered inert, and thus does not change semiconductor properties as a result of interaction with air or other materials in contact with the surface or edge of the crystal. Passivation can also mean that a silicon surface of the semiconductor wafer is shielded from external charges, also referred to as electro-active passivation. Passivation is typically achieved using a form of thermal oxidation, for example by oxidation to a coating of silicon dioxide or by deposition of a layer with electro-passivation properties. The semiconductor wafer being immersed and/or surrounded by the isolating medium means that the semiconductor wafer is at least partially or completely immersed and/or surrounded by the isolating medium. The semiconductor wafer may further comprise at least one junction.

According to a modified implementation, the isolating medium hermetically seals the junction termination and/or the contact element. Thus, at least the junction termination is for example completely surrounded by the isolating medium, which such ways hermetically seals the junction termination. Thereby the junction termination can be in direct contact with the isolating medium.

According to a further modified implementation, the dielectric liquid is an organic or synthetic oil. The dielectric liquid may comprise mineral oil, silicone oil, n-Hexane, n-Heptane or other dielectric liquid known to the person skilled in the art that provide electrical insulation and thus suppress corona and arcing. In this respect gels are not considered to constitute insulating mediums.

According to another modified implementation, the pressurized dielectric gas comprises one of sulfur hexafluoride, SF₆, nitrogen, N₂, dry air, fluorinated organic gases, and mixtures comprising at least one of the before mentioned components, and/or wherein the pressurized dielectric gas comprises a pressure of ≥ 120 kPa and ≤ 50 MPa. The pressure can also be in the range of ≥ 120 kPa and ≤ 1 MPa. Humidity level of said gases can be limited to a value to avoid condensation at a given pressure and minimum operating temperature, such as at 0 °C. Fluorinated organic gases may comprise perfluorohexane or other fluorinated organic gases known to the person skilled in the art. The pressurized dielectric gas may also comprise Fluorinert^{™} or AirPlus gas mixture, in particular C5-Fluoroketone (C5 FK). Beside that any dielectric gas can be used that provides electrical insulation and thus suppresses corona and arcing.

In a further modified implementation, the vacuum has a pressure ≤ 10⁻⁴ Pa. The pressure may also be ≤ 10⁻² Pa, ≤ 10⁻³ Pa, ≤ 10⁻⁵ Pa or ≤ 10⁻⁶ Pa. Vacuum means in particular that a mean free path, MFP, of residual gases is longer than the size of the chamber or of the object under test.

According to another modified implementation, the passivation comprises at least one of diamond-like carbon, polyimide, epoxy mold compound, parylene, borosilicate glass, hydrophobic layer and phenol resin. The phenol resin can be provided as WPR and may comprise rubber particles, for such way providing reliable insulation and high dielectric strength in the range of 380 kV/mm. Diamond-like carbon can be provided as thin film carbon coating, in particular as plasma polymer films, amorphous carbon films, CVD diamond films as well as graphite films. Said carbon films can be manufactured by deposition using a gas-phase deposition processes in most cases taking place in a vacuum by using chemical vapor deposition, CVD or physical vapor deposition, PVD. The film thicknesses are typically a few hundred nanometers for diamond like carbon, DLC, passivation or up to tens of micrometers for polyimide.

According to a further modified implementation, the semiconductor wafer is provided as silicon or silicon carbide bipolar wafer. The semiconductor wafer, also called a slice or substrate, is often a thin slice of semiconductor such as a crystalline silicon (c-Si), GaN or other semiconductor materials. A semiconductor wafer has typically a round shape with a diameter of 30 mm to 450 mm, for example 30 mm to 150 mm, and a respective thickness of 300 µm to 1500 µm, and is thus often referred to as disc or disc-like wafer.

According to another modified implementation, the power semiconductor device comprises a top leadframe and a base leadframe, whereby the semiconductor wafer is sandwiched between the top leadframe and the base leadframe, and the top leadframe. The power semiconductor device may further comprise a top plate and a base plate, whereby the semiconductor wafer and the base leadframe are sandwiched between the top plate and the base plate. The semiconductor wafer may, in side view, overtop the top plate, the base plate, the top leadframe and the base leadframe on both sides. The top plate, the base plate, the top leadframe and the base leadframe may have a corresponding shape and/or an equal shape as the semiconductor wafer, for example a round respectively disc or disc-like shape. The top leadframe may be directly, gap-free and/or touching attached to the top plate and/or to the semiconductor wafer, for example by bonding or the like. The base leadframe may be directly, gap-free and/or touching attached to the semiconductor wafer and/or the base plate, for example by bonding (soldering, sintering, adhesive bonding) or the like. The top plate and the base plate can be provided as metal plates.

In a further modified implementation, the top leadframe and/or the base leadframe are provided as molybdenum discs. Alternatively, the top leadframe and/or the base leadframe may comprise Cu or CuMo. The base leadframe and/or the top leadframe can be provided as thick-metal leadframes. The base leadframe and/or the top leadframe can be based on Cu and bonding can be conducted by sintering into cavities of the respective leadframe.

According to another modified implementation, the top plate and/or the base plate are provided as cooling elements and/or as heatsinks for cooling the semiconductor wafer. The cooling elements may comprise a moving fluid, for example, air, cooling gas or liquid, or a cooling channel. In such regard the base plate and/or the top plate are also referred to as cooler. Thus, cooling capability can be supplied to both sides of the semiconductor wafer.

In a further modified implementation, the power semiconductor device comprises a plurality of semiconductor wafers arranged on top of each other. The semiconductor wafers can be directly, gap-free and/or touching arranged to each other. Such way the plurality of semiconductor wafers is stacked.

According to another modified implementation, the power semiconductor device comprises a junction termination ring or an alignment ring encapsulating the junction terminations of the semiconductor wafers. According to a further modified implementation, the junction termination ring or the alignment ring comprises, in side view, a U-shape. The junction termination ring or the alignment ring may also comprise an asymmetric shape, for example an L-shape. The junction termination ring may comprise an oil-compatible material, such as for example Epoxy, Hybrid Epoxy with an imide compound, or other corrosive gas- or vacuum-compatible material. The housing-less semiconductor wafers clamped in a stack can be easily centered with the junction termination ring. Such housing-less semiconductor wafers with an oil-compatible junction termination ring can be readily manufactured by using a single-step transfer molding process with epoxy-molding compound. Power semiconductor device material compatibility with the environment medium, for example dielectric liquid, is necessary, so that impurities are not released, for example when materials soak in the oil or other insulating mediums, especially when temperature increases. However, diamond like carbon material and composition of the materials used for junction termination ring showed readily good compatibility with organic oil both under room and elevated temperatures (such as 125°C). The alignment ring can be added to the semiconductor wafer and removed from the semiconductor wafer after assembly into a stack.

The object is further solved by a use of the power semiconductor device as described before in a subsea converter, a transformer tap changer or a high voltage direct current converter. The proposed 'housing less' power semiconductor device can be advantageously used for subsea converters and transformer tap changers, or next generation HVDC compact converters, high vacuum power generations space applications and other oil-containing or pressurized gas-containing applications, as the power semiconductor device is tolerant against high hydrostatic external pressure above atmospheric pressure, or high vacuum below for example 10⁻⁴ Pa.

The object is even further solved by method for manufacturing a power semiconductor device, comprising
a semiconductor wafer having at least one contact element and a passivated junction termination laterally surrounding the at least one contact element, and
an insulating medium selected from the group consisting of a dielectric liquid, a pressurized dielectric gas and a vacuum, and comprising the step of
immersing and/or surrounding the semiconductor wafer by the insulating medium.

Further implementations and advantages of the use and of the method are directly and unambiguously derived by the person skilled in the art from the device as described before.

### Brief description of the drawings

These and other aspects of the invention will be apparent from and elucidated with reference to the implementations described hereinafter.

In the drawings:
Fig. 1 shows in a side a view a power semiconductor device according to an exemplary implementation,
Fig. 2 shows in a side view the power semiconductor device according to a further exemplary implementation,
Fig. 3 shows in a side view the power semiconductor device according to a further exemplary implementation,
Fig. 4 shows in a side view the power semiconductor device according to a further exemplary implementation,
Fig. 5 shows in a side view the power semiconductor device according to a further exemplary implementation, whereas the implementation corresponds to the implementation shown in Fig. 2,
Fig. 6 shows in a side view the power semiconductor device according to a further exemplary implementation, whereas the implementation corresponds to the implementation shown in Fig. 3,
Fig. 7 shows in a side view the power semiconductor device according to a further exemplary implementation, whereas the implementation corresponds to the implementation shown in Fig. 4,
Fig. 8 shows in a side view the power semiconductor device according to a further exemplary implementation, whereas the implementation corresponds to the implementation shown in Fig. 7, and
Fig. 9 shows in a side view the power semiconductor device according to two further exemplary implementation.

### Detailed Description of exemplary implementations

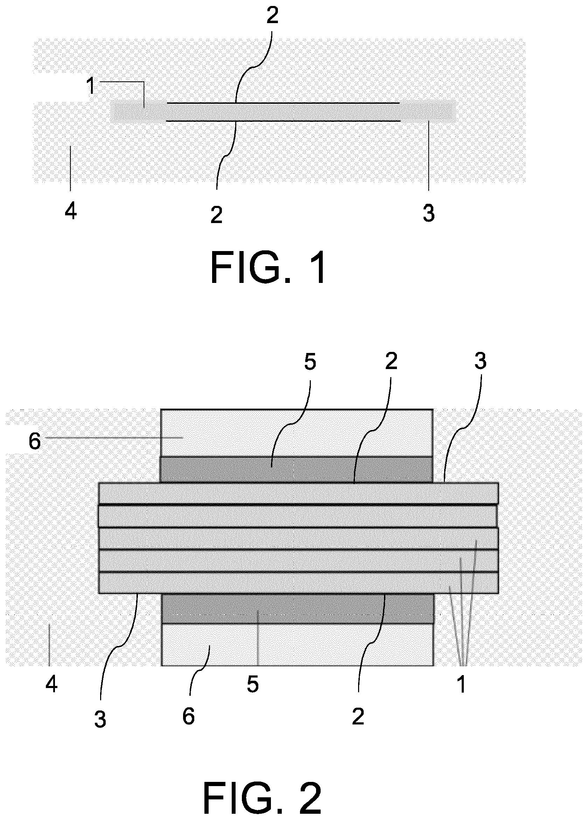

Fig. 1 shows in a side view a power semiconductor device according to an exemplary implementation, which comprises a silicon or silicon carbide bipolar semiconductor wafer 1 having a disc-like shape with a diameter of 30 mm to 200 mm, and a respective thickness of 300 µm to 1500 µm.

The semiconductor wafer 1 comprises two contact elements 2 as electric contacts respectively electrodes, which are arranged opposite to each other at the longitudinal surfaces of the disc-like shape, and are also referred to as main sides. The contact elements 2 are surrounded by junction terminations 3, which are arranged at lateral sides of the semiconductor wafer 1 between the opposite contact elements 2. The junction terminations 3 are diamond like carbon, DLC, passivated. Instead of DLC the passivation may comprise polyimide, epoxy mold compound, parylene, borosilicate glass, hydrophobic layer or phenol resin. The semiconductor wafers 1 are configured for use in high voltage application such as 1.2, 2.8, 3.3, 4.5, 5.2, 6.5, 7.2, 8.5 ,10 or 20 kV.

The semiconductor wafer 1 is surrounded by an insulating medium 4 selected from the group consisting of a dielectric liquid, a pressurized dielectric gas and a vacuum, which thus hermetically seals the junction termination 3. Such way the semiconductor device is provided 'without' a housing. The dielectric liquid is an organic or synthetic oil. The dielectric gas comprises sulfur hexafluoride, SF₆, nitrogen, N₂, dry air, fluorinated organic gases, or mixtures thereof. The pressurized dielectric gas requires a pressure of ≥ 120 kPa and ≤ 50 MPa, and in particular ≤ 1 MPa. The vacuum requires a pressure ≤ 10⁻⁴ Pa.

Fig. 2 shows in a side view the semiconductor device according to a further exemplary implementation, whereby a plurality of semiconductor wafers 1 are arranged on top of each other. Two molybdenum discs are attached as top leadframe respectively base leadframe 5 on both contact elements 2. Two metal housing pole pieces are attached as top plate respectively base plate 6 onto the top leadframe respectively base leadframe 5 such that the top plate and the base plate 6 'sandwich' the top leadframe and base leadframe 5, whereas the latter two 'sandwich' the semiconductor wafer 1. The semiconductor wafer 1 overtops on both sides with the junction terminations 3 the top leadframe and base leadframe 5. Top plate and/or the base plate 6 comprise a cooler element 9, not explicitly shown in Fig. 2, for cooling the semiconductor wafer 1. Thus, Top plate and/or the base plate 6 are also referred to as cooler.

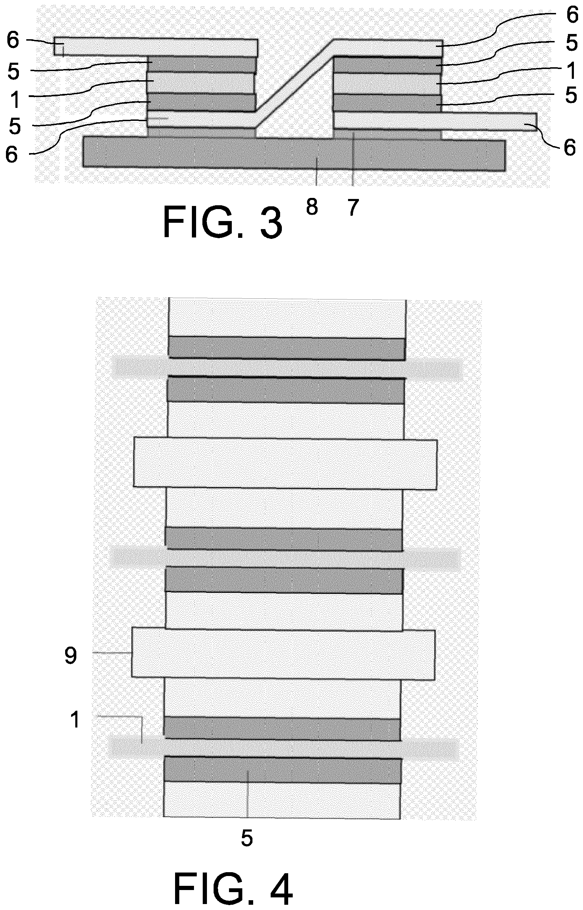

Fig. 3 shows in a side view the semiconductor device according to a further exemplary implementation, whereas two semiconductor wafers 1 are arranged besides each other and connected in series. As described before, each semiconductor wafer 1 is electrically 'sandwiched' between the top leadframe and base leadframe 5. Top leadframe and base leadframe 5 are also electrically 'sandwiched' between top plate and the base plate 6. However, base plate 6 of the left semiconductor device is provided one piece and thus connected with the top 6 of the right semiconductor device for forming the series connection. Such way the top plate 6 of the left semiconductor device and the base plate 6 of the right semiconductor device form electrical contacts for connection the semiconductor devices. Both semiconductor devices are arranged via an insulating layer 7 on a base 8.

Fig. 4 shows in a side view the semiconductor device according to a further exemplary implementation, whereby three semiconductor devices are directly stacked on top of each other. A separate cooler element 9 is provided between each base plate 6 of the upper semiconductor device and the top plate 6 of the lower semiconductor device comprising cooling channels.

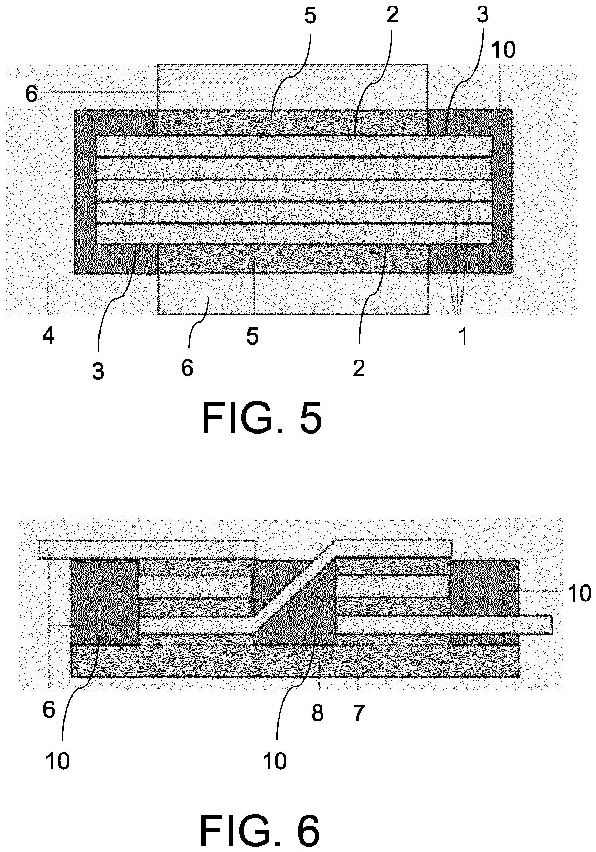

Figs. 5 to 7 show in a side view semiconductor devices according to a further exemplary implementation, whereas the semiconductor devices relate to the implementations as described before in respect to Figs. 2 to 4. In addition to the implementations described before, a junction termination ring 10 is provided which laterally encapsulates the junction termination 3 of the respective semiconductor wafer 1. The junction termination ring 10 comprises an oil-compatible material such as epoxy or hybrid epoxy with an imide compound, or other corrosive gas- or vacuum-compatible material. Due to the junction termination ring 10, the housing-less semiconductor wafers 1 are centered while clamped in a stack.

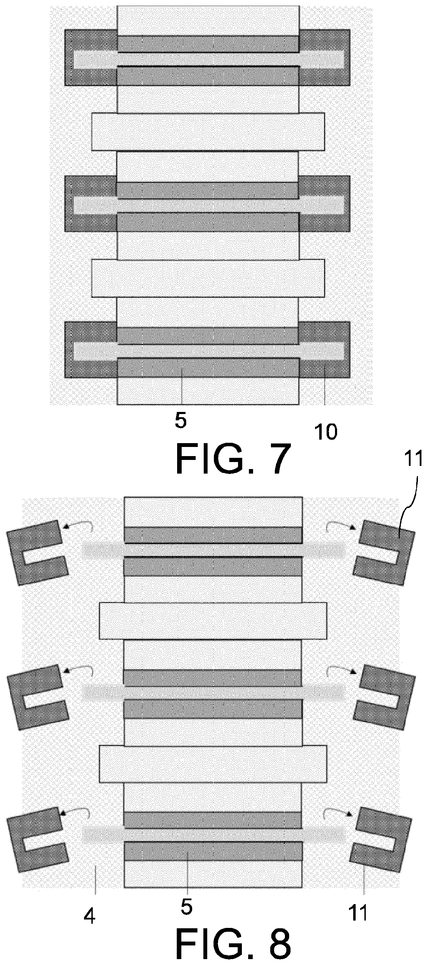

As shown in Fig. 5, the junction termination ring 10 laterally encapsulates all semiconductor wafers 1 arranged one above the other. In Fig. 6, wherein the semiconductor wafers 1 do not overtop in longitudinal direction the base leadframe and the top leadframe 5, the junction termination ring 10 also encapsulates the base leadframe and the top leadframe 5, and the base plates 6 of the two semiconductor devices. In the implementation shown in Fig. 7, each semiconductor wafer 1 is encapsulated at its lateral junction terminations 3 with said junction termination ring 10.

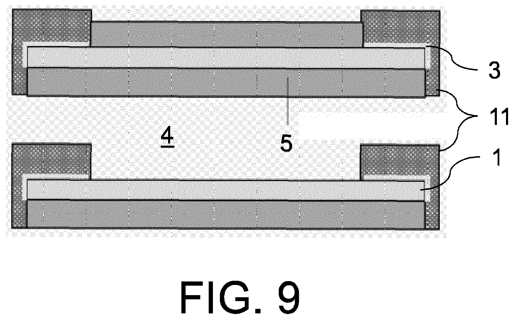

Fig. 8 shows in a side view the semiconductor device according to a further exemplary implementation, which corresponds to the implementation shown in Fig. 7. Instead of the junction termination ring 10, an alignment ring 11 is provided for centering the semiconductor wafers 1 arranged in a stack. The alignment ring 11 also comprises a U-shape in side view, but is removed from the semiconductor wafers 1 after assembly of the semiconductor wafers 1 into the stack. Other shapes may include an L-shape or an asymmetric shape, as can be seen in Fig. 9 showing two possible implementations having an L-shape.

The described power semiconductor can be advantageously used for example in a subsea converter, a transformer tap changer or a high voltage direct current converter, or within a next generation HVDC compact converters, and other oil-containing or pressurized gas-containing applications. Thereby, the insulating medium is 'housed' respectably encapsulated by a respective housing of the converter, tap changer or the application. In prior art application thin housing flanges extend from the top plate respectively the base plate 6 usually lack mechanical stability if the stack was to be immersed deep under water or in outer space with high vacuum. In contrast thereto the proposed 'housing less' power semiconductor device is tolerant against high hydrostatic external pressure above atmospheric pressure, or high vacuum below 10⁻⁴ Pa.

While the invention has been illustrated and described in detail in the drawings and foregoing description, such illustration and description are to be considered illustrative or exemplary and not restrictive; the invention is not limited to the disclosed implementations. Other variations to be disclosed implementations can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 1: semiconductor wafer
- 2: contact element
- 3: junction termination
- 4: insulating medium
- 5: top leadframe, base leadframe
- 6: top plate, base plate
- 7: insulating layer
- 8: base
- 9: heat sink, cooler element
- 10: junction termination ring
- 11: alignment ring

## Claims

1. A power semiconductor device, comprising
a semiconductor wafer (1) having at least one contact element (2) and a passivated junction termination (3) laterally surrounding the at least one contact element (2), and
an insulating medium (4) selected from the group consisting of a dielectric liquid, a pressurized dielectric gas and a vacuum, wherein
the semiconductor wafer (1) is surrounded by the insulating medium (4).

2. The power semiconductor device according to the previous claim, whereby the insulating medium (4) hermetically seals the junction termination (3).

3. The power semiconductor device according to any of the previous claims, whereby the dielectric liquid is an organic or synthetic oil.

4. The power semiconductor device according to any of the previous claims, whereby the pressurized dielectric gas comprises one of sulfur hexafluoride, SF₆, nitrogen, N₂, dry air, fluorinated organic gases, and mixtures comprising at least one of the before mentioned components, and/or wherein the pressurized dielectric gas comprises a pressure of ≥ 120 kPa and ≤ 50 MPa, in particular ≤ 1 MPa.

5. The power semiconductor device according to any of the previous claims, whereby the vacuum has a pressure ≤ 10⁻⁴ Pa.

6. The power semiconductor device according to any of the previous claims, whereby the passivation comprises at least one of diamond-like carbon, polyimide, epoxy mold compound, parylene, borosilicate glass, hydrophobic layer and phenol resin.

7. The power semiconductor device according to any of the previous claims, whereby the semiconductor wafer (1) is provided as silicon or silicon carbide bipolar semiconductor wafer (1).

8. The power semiconductor device according to any of the previous claims, comprising a top leadframe (5) and a base leadframe (5), whereby the semiconductor wafer (1) is sandwiched between the top leadframe (5) and the base leadframe (5), and/or comprising a top plate (6) and a base plate (6), whereby the top leadframe (5), the semiconductor wafer (1) and the base leadframe (5) are sandwiched between the top plate (6) and the base plate (6).

9. The power semiconductor device according to the previous claim, whereby the top leadframe (5) and/or the base leadframe (5) are provided as molybdenum discs.

10. The power semiconductor device according to any of the two previous claims, whereby the top plate (6) and/or the base plate (6) are provided as cooling elements (9) for cooling the semiconductor wafer (1).

11. The power semiconductor device according to any of the previous claims, comprising a plurality of semiconductor wafers (1) arranged on top of each other.

12. The power semiconductor device according to any of the previous claims, comprising a junction termination ring (10) or an alignment ring (11) encapsulating the junction termination (3) of the semiconductor wafer (1).

13. The power semiconductor device according to the previous claim, whereby the junction termination ring (10) or the alignment ring (11) comprises, in side view, a U-shape or L-shape.

14. Use of the power semiconductor device according to any of the previous claims in a subsea converter, a transformer tap changer or a high voltage direct current converter.

15. Method for manufacturing power semiconductor device, comprising
a semiconductor wafer (1) having at least one contact element (2) and a passivated junction termination (3) laterally surrounding the at least one contact element (2), and
an insulating medium (4) selected from the group consisting of a dielectric liquid, a pressurized dielectric gas and a vacuum, and comprising the step of
surrounding the semiconductor wafer (1) by the insulating medium (4).
